# EUROPEAN PATENT APPLICATION

(11) **EP 4 589 665 A1**
(43) Date of publication of application: **23.07.2025**
(21) Application number: 24153187.0
(22) Date of filing: 22.01.2024
(51) Int. Cl.: H01L 31/048, B64G 1/22, B64G 1/44, H01L 31/05, H02S 20/30, H02S 20/32, H02S 30/20

(54) **FLEXIBLE PHOTOVOLTAIC ASSEMBLY, SOLAR PANEL, SPACECRAFT AND METHOD FOR MANUFACTURING A FLEXIBLE PHOTOVOLTAIC ASSEMBLY**

(71) Applicant: Airbus Defence and Space GmbH, 82024 Taufkirchen (DE)
(72) Inventor: Übner, Andreas, 82024 Taufkirchen (DE)
(74) Representative: Isarpatent

(57) **Abstract**

The present invention provides a flexible photovoltaic assembly (100) comprising: a first attachment unit (101) and a second attachment unit (102) spaced apart from the first attachment unit (101); a flexible strap device (103), which is attached to the first attachment unit (101) and to the second attachment unit (102); and at least one solar cell unit (104), which is attached to the flexible strap device (103). Moreover, the present invention provides a solar panel (10) containing such a flexible photovoltaic assembly (100) as well as a spacecraft (1) containing such a solar panel (10). Further, the present invention provides a method for manufacturing a flexible photovoltaic assembly.

## Description

The invention relates to a flexible photovoltaic assembly as well as to a solar panel comprising such a flexible photovoltaic assembly. The invention is furthermore concerned with a spacecraft containing such a solar panel. Further, the invention relates to a method for manufacturing a flexible photovoltaic assembly.

Most space vehicles are typically powered by solar energy, which is provided by solar generators being attached to the vehicle, either directly mounted to the object or as a deployable structure, most commonly seen on satellites and space stations.

For example, the document US 2015/0274327 describes a deployable satellite solar generator wing with at least two fixed solar panels and at least one semi-fixed solar panel are connected to one another so that the solar panels can assume an operating position and a transport position.

Such standard solar generators need to be stowed in a compact volume when mounted for the launch on the space vehicle (transport position) and will be deployed to increase the surface area to collect a maximum amount of sunlight that will be converted into electrical power by the solar cells (operating position).

Large power requests for the space vehicles require an enormous amount of energy that needs to be provided by the solar generator, which defines the surface area of the solar generator, depending on the type and efficiency of the solar cells. Usually, the surface area is increased by increasing the number or size of the panels. Nevertheless, there are limiting factors for the panel dimension, which is usually the size of the satellite. The number of panels can be increased, but with the increased mass, additional reinforcement elements are required to achieve reasonable mechanical behavior, which usually leads to additional mass.

The electrical relevant photovoltaic assembly (PVA) usually consists of solar cells, which are electrically connected by interconnectors to so-called solar cell strings, and which are protected and enhanced by bonded cover glasses. This assembly is usually bonded to a support structure with silicone adhesives.

The rigid support structure is commonly designed as a sandwich panel with carbon fiber reinforced plastics (CFRP) face sheets and an aluminum honeycomb core. This design is reasonable electrically conductive. Therefore, an insulation film, typically a polyimide film, separates the PVA from the support structure.

A function of the rigid panels is to provide stiffness to the solar generator and to prevent critical bending of the solar cells and/or the cover glasses, which might result in fracture of the solar cell.

Providing stiffness throughout the complete structure has been proved an efficient way of providing surface for the photovoltaic assembly (PVA). Nevertheless, using rigid structures are usually being traded against mass and for instance deployed Eigenfrequencies, which are dropping due to the high mass. Also, thermal management of the solar panel can be challenging, as the solar cell efficiency is reduced with higher cell temperatures. The cell side of the panel is illuminated with the solar radiation and the heat has to be emitted from the rear side of the panel in order to keep the temperatures on an acceptable level. Therefor a heat flow has to pass through the panel from the front to the rear side, which is generally more difficult on thicker and more massive substrates.

In general, these known type of solar array structures consist in a large part of mechanically unused mass, which does not contribute to the overall wing performance.

To lower the mass of the supporting components which are not generating power, different concepts of flexible support structures for the PVA, which are somehow tensioned, have been established over the years. The most common types are the space station like solar arrays, which is basically a Z-folded flexible blanket stack stowed between two rigid plates, which is then deployed. Another approach are rollable solar arrays. Both types have the potential for mass optimization, but also have drawbacks. Usually, these concepts are rather complex in e.g. their mechanism design, dynamic in orbit behavior, deployment process and on-ground testing approach. Even though this leads to a high development effort, these layouts are often required due to space constraints on the spacecraft, where no standard array with rigid panel fits into the available volume.

Taking the above mentioned issues into account, an object of the present invention is to provide a flexible photovoltaic assembly as well as a solar panel, which has the advantages of a standard rigid solar array and also takes advantage of a flexible solar cell support.

According to the invention, this problem is solved in each case by the subject matters of the independent claims.

According to a first aspect of the invention, a flexible photovoltaic assembly is provided. The flexible photovoltaic assembly comprises a first attachment unit and a second attachment unit spaced apart from the first attachment unit. The flexible photovoltaic assembly further comprises a flexible strap device, which is attached to the first attachment unit and to the second attachment unit, and at least one solar cell unit. The at least one solar cell unit is attached to the flexible strap device.

According to a second aspect of the invention, a solar panel is provided. The solar panel comprises a panel frame, which at least partly surrounds a planar installation area or panel plane, respectively. Furthermore, the solar panel comprises a first flexible photovoltaic assembly according to the first aspect of the invention. The first flexible photovoltaic assembly is arranged in the planar installation area and mounted to the panel frame by means of its first and second attachment unit.

According to a third aspect of the invention, a spacecraft is provided. The spacecraft comprises a solar generator wing with a solar panel according to the second aspect of the invention.

According to a fourth aspect of the invention, a method for manufacturing a flexible photovoltaic assembly, in particular a flexible photovoltaic assembly according to the first aspect of the invention, is provided. The method comprises a step of attaching a flexible strap device to a first attachment unit and a second attachment unit. The second attachment unit is spaced apart from the first attachment unit. Further, the method comprises a step of providing at least one solar cell unit and a step of attaching the at least one solar cell unit to the flexible strap device.

A fundamental concept of the invention is to provide a solar panel or hybrid solar array, respectively, which comprises the global behavior of a standard rigid panel solar array with a mass optimization of a flexible solar array or flexible photovoltaic assembly, respectively. Thereby, functions of the solar panel can be separated. The panel frame is substantially configured rigid, which provides the global stiffness and contributes to the mechanical solar generator wing system performance, in particular in a deployed mode.

Attached to the panel frame towards the inside is the flexible strap device, working as a flexible support structure, with the solar cell unit or power generating element, respectively. The flexible photovoltaic assembly provides the power generation. The panel frame provides the mechanical system layout.

When using the panel frame, a solar panel stiffness is easily scalable to the required global stiffness by dimensioning a panel frame profile, which can be acting as a bending beam element, for example.

The step of attaching the flexible strap device and the step of providing at least one solar cell unit can be performed parallel, in particular simultaneously.

A particular advantage in the solution according to an aspect of the invention is that the panel frame in a stowed and a deployed configuration provides the required global stiffness, more optimized than a known rigid panel solar array.

In particular, in comparison to a known sandwich panel, almost all structural material of the solar panel according to the present invention is more concentrated in the panel frame and increases stiffness and strength to a maximum extend. Advantageously, more material is in a direct load path and will contribute to the global stiffness and strength. A mass of the solar panel can be reduced.

Furthermore, an integration process of the present invention to the spacecraft and an on-ground test sequence can be very similar to the standard way of working, which means that also similar facilities and equipment can be used. Therefore, costs can be reduced.

Another advantage of the present invention is that the design of the frame-based solar panel can be adjusted to be compatible to many other solar array components. For example, panel interfaces can be similar and an identical deployment mechanism, for example identical deployment hinges, can be used. Hence, using building blocks of qualified components such as root hinge, yoke and so on for both types of solar panel can significantly reduce costs. Furthermore, the present invention can be combined or integrated in a lot of different existing solar generator concepts, basically any concept that is using rigid or semi-rigid solar panels. For example, existing rigid panels can be combined with hybrid panels according to the present invention.

From experience of current solar generators using state-of-the-art lightweight panel substrates, a specific substrate weight above 1.0 - 1.5 kg per m² is reasonable without solar cells, cabling etc. Thus, the present invention can reduce the substrate mass up to 50 % compared to the known panels, depending on a load scenario, such as for the deployed Eigenfrequency. By reducing the substrate mass, also a mass of mounting devices for mounting the solar panel to the spacecraft can be reduced, since they do not need to withstand the higher loads as before.

Alternatively or additionally, the substrate mass can be maintained and can contribute to improve significantly the mechanical properties of the solar panel, such as panel stiffness.

Advantageous embodiments and further developments emerge from the description with reference to the figures.

According to some embodiments of the present invention, the at least one solar cell unit is attached to the flexible strap device by a material bonding like welding, adhesion or similar, by a form fit like a velcro fastener, a lug tab connection or similar, and/or by a press fit like clamps, a magnetic connection or similar.

According to some further embodiments of the present invention, the flexible strap device is configured to be isolated or non-conductive. Hence, the flexible strap device is electrically insulated, for example by an insulation film, in order to prevent electrical short circuiting. In particular, when a conductive material, like carbon fibers, is used for the flexible strap device, the flexible strap device can be conductive on their surface due the high electrical conductivity of the carbon.

For example, an insulating coating, like a polyimide film or similar, can be provided on at least sections of the surface of the flexible strap device to provide a robust electrical insulation. The insulating coating can have a thickness of about 50 µm.

According to some further embodiments of the present invention, the at least one solar cell unit comprises a plurality of solar cell units, which are arranged in series between the first and the second attachment unit, wherein adjacent solar cell units of the plurality of solar cell units are electrically connected by a solar cell interconnector. The solar cell interconnector can be configured mechanically flexible, in particular bendable. Thus, the solar cell interconnector can provide a mechanical flexibility to the adjacent solar cell units such that they can pivot relative to each other. The plurality of solar cell units in series can also be called a solar cell string.

According to some further embodiments of the present invention, the first and/or second attachment unit comprises a tensioning mechanism for tensioning the flexible strap device when mounted to a panel frame. Hence, an applied pre-tension on the flexible strap device can substantially be kept constant. For example, the tensioning mechanism comprises or is configured as a tension spring.

According to some further embodiments of the present invention, the at least one solar cell unit has a rear side for attaching the flexible strap device, wherein the rear side is facing the flexible strap device and at least sectionwise has a black surface. For example, a part of the rear side is facing deep space, except the area above the flexible strap device, and can get rid of the heat by radiating into deep space. Thus, thermo-optical properties leading to moderate cell temperatures and a higher cell efficiency can be improved.

The solar cell unit can comprise a solar cell and a cover glass on top of the solar cell. The cover glass can be bonded to the solar cell by a cover glass adhesive. In particular, the cover glass corresponds to a front side of the solar cell unit. Furthermore, the solar cell can be bonded to the flexible strap device by a solar cell adhesive. The solar cell adhesive can be provided on the rear side of the solar cell unit.

According to some further embodiments of the present invention, the at least one solar cell unit comprises a bi-facial solar cell having a front side and a rear side, wherein the rear side faces away from the sun and converts light into power, which is reflected, in particular reflected from the earth towards the rear side. As a result, an efficiency of power generating can be further improved.

Optionally, the flexible strap device comprises two, three or four straps, which extend parallel between the first and the second attachment unit. Alternatively, the flexible strap device comprises one strap, which extends parallel between the first and the second attachment unit.

In the meaning of the present invention a flexible strap device comprising two straps, which extend parallel between the first and the second attachment unit, also includes one strap that is fixed with its both ends to the first attachment unit and turned round at the second attachment unit. For example, the strap can be turned round by a return pulley or similar.

Optionally, the first and/or second attachment unit comprises a tension rocker.

According to some further embodiments of the present invention, the first flexible photovoltaic assembly is tensioned in the panel frame with a predetermined pre-tension. As a result, the predetermined pre-tension in the tensioned strap device can be adjusted to requirements such as Eigenfrequency, maximum deflection or similar requirements. The predetermined pre-tension can be exactly adjusted by using a tension spring and/or a tension rocker for each flexible strap device.

Hence, an even load distribution throughout the complete solar panel can be improved.

According to some further embodiments of the present invention, the solar panel further comprises a second flexible photovoltaic assembly, which extends parallel to the first flexible photovoltaic assembly in the planar installation area and is mounted to the panel frame by means of its first and second attachment unit. In particular, the first flexible photovoltaic assembly and the second flexible photovoltaic assembly are independent from each other.

For example, the second flexible photovoltaic assembly is mechanically coupled to the first flexible photovoltaic assembly. Thus, a risk of collision between the first and the second flexible photovoltaic assembly can be reduced. For example, they can be mechanically coupled by a shared strap or by a cross coupling such as a bonded string or strap. The first and the second flexible photovoltaic assembly are thereby adjacent flexible photovoltaic assemblies.

According to some further embodiments of the present invention, the solar panel further comprises a panel frame stiffener for stiffening the panel frame, wherein the panel frame stiffener is arranged in the planar installation area and extends parallel or perpendicular in relation to the first flexible photovoltaic assembly.

Alternatively or additionally, the solar panel further comprises a panel frame stiffener for stiffening the panel frame, wherein the panel frame stiffener is arranged in the planar installation area and extends perpendicular in relation to the first flexible photovoltaic assembly, and wherein the first flexible photovoltaic assembly is mounted to the panel frame stiffener with its first or second attachment unit.

According to some further embodiments of the present invention, the solar panel further comprises a bumper, which is arranged at the rear side of the at least one solar cell unit in a transport position, in which the solar panel is retained on top of another solar panel. Hence, an out-of-plane deflection of the flexible strap device can be reduced. Furthermore, a direct contact between the solar cell units can be prevented during vibration and the amplitude can be reduced. For example, the bumper can be configured as a honeycomb bumper. The bumper can be attached to the rear side of the solar cell unit or to the opposite side of the flexible strap device in relation to the solar cell unit such that the bumper is not in direct contact with the rear side.

According to some further embodiments of the present invention, the first flexible photovoltaic assembly or its at least one solar cell unit has an angle relative to the planar installation area. Hence, a variable adjustment with pre-defined angles could be provided. Therefore, the angle of the solar cell unit can be adjusted depending on different missions. Moreover, solar generator wings can be completely identical in the overall design, which is a big advantage. The angle can be predetermined and provided by an anti-twist protection or by a correspondingly configured attachment unit, for example.

According to some further embodiments of the present invention, the first and the second attachment unit comprises a controllable tilting drive for automatically adjusting the angle depending on an inclination of the sun. For example, an alignment mechanism integrated in the panel frame can be used.

For example, the panel frame is made of a carbon fiber reinforced plastic (CFRP) or an aluminum.

According to some further embodiments of the present invention, the step of providing at least one solar cell unit includes arranging a plurality of solar cell units in series between the first and the second attachment unit, and electrically connecting adjacent solar cell units of the plurality of solar cell units by a solar cell interconnector.

According to some further embodiments of the present invention, the method further comprises a step of integrating a tensioning mechanism into the first and/or second attachment unit for tensioning the flexible strap device when mounted to a panel frame.

The present invention is explained more specifically below on the basis of the exemplary embodiments indicated in the schematic figures, in which:
- Fig. 1: shows a schematic illustration of a spacecraft with a solar generator wing according to an embodiment of the invention;
- Fig. 2: shows a schematic illustration of a solar panel according to a further embodiment of the invention;
- Fig. 3: shows a schematic illustration of a solar panel with a panel frame stiffener according to a further embodiment of the invention;
- Fig. 4: shows a schematic side view of a plurality of solar panels with a bumper in a transport position according to a further embodiment of the invention;
- Fig. 5: shows a schematic illustration of a solar panel with flexible photovoltaic assemblies having an angle relative to the planar installation area according to a further embodiment of the invention;
- Fig. 6: shows a schematic illustration of a panel frame and a plurality of independent flexible photovoltaic assemblies according to a further embodiment of the invention;
- Fig. 7: shows a schematic illustration of flexible photovoltaic assembly according to a further embodiment of the invention;
- Fig. 8: shows a schematic illustration of an attachment unit of the flexible photovoltaic assembly of Fig. 7;
- Fig. 9: shows a schematic illustration of the flexible photovoltaic assembly of Fig. 7 having solar cell units arranged in series;
- Fig. 10: shows a schematic cross-sectional detail view of adjacent solar cell units being electrically connected by a solar cell interconnector according to a further embodiment of the invention; and
- Fig. 11: shows a flow chart for a method for manufacturing a flexible photovoltaic assembly according to a further embodiment of the invention.

The accompanying figures are intended to convey a further understanding of the embodiments of the invention. They illustrate embodiments and are used in conjunction with the description to explain principles and concepts of the invention. Other embodiments and many of the cited advantages emerge in light of the drawings. The elements of the drawings are not necessarily shown to scale in relation to one another. Direction-indicating terminology such as for example "at the top", "at the bottom", "on the left", "on the right", "above", "below", "horizontally", "vertically", "at the front", "at the rear" and similar statements are merely used for explanatory purposes and do not serve to restrict the generality to specific configurations as shown in the figures.

In the figures of the drawing, elements, features and components that are the same, have the same function and have the same effect are each provided with the same reference signs - unless explained otherwise.

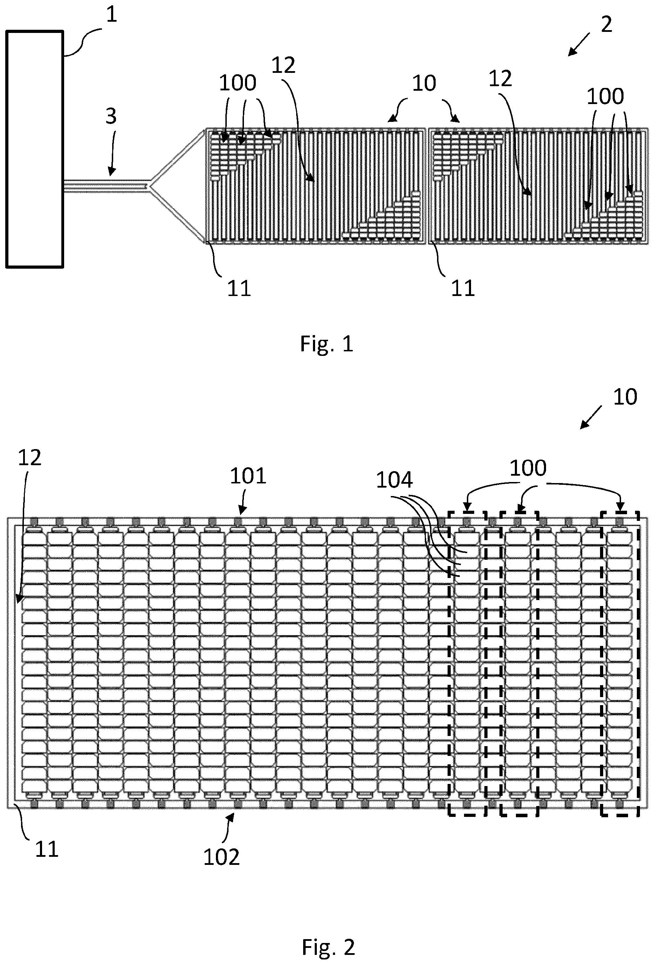

Fig. 1 shows a schematic illustration of a spacecraft 1 with a solar generator wing 2.

The solar generator wing 2 comprises two solar panels 10. Furthermore, the solar generator wing 2 comprises a yoke 3 for mounting the solar generator wing 2 to the spacecraft 1.

Each solar panel 10 comprises a panel frame 11 and at least one flexible photovoltaic assembly 100. The panel frame 11 at least partly surrounds a planar installation area 12 or panel plane, respectively.

The at least one flexible photovoltaic assembly 100 is arranged in the panel plane 12 and mounted to the panel frame 11 by means of its first and second attachment unit 101, 102 as it is illustrated in Fig. 2. The flexible photovoltaic assembly 100 comprises a first attachment unit 101 and a second attachment unit 102 spaced apart from the first attachment unit 101 as well as a flexible strap device 103, which is attached to the first attachment unit 101 and to the second attachment unit 102, and at least one solar cell unit 104, which is attached to the flexible strap device 103.

Fig. 2 shows a schematic illustration of a solar panel 10. The solar panel 10 comprises a panel frame 11 and a plurality of flexible photovoltaic assemblies 100.

The panel frame 11 at least partly surrounds a planar installation area 12 or panel plane, respectively.

The plurality of flexible photovoltaic assemblies 100 is arranged in the panel plane 12 and mounted to the panel frame 11 by means of its first and second attachment unit 101, 102. Each flexible photovoltaic assembly 100 comprises a first attachment unit 101 and a second attachment unit 102 spaced apart from the first attachment unit 101 as well as a flexible strap device 103, which is attached to the first attachment unit 101 and to the second attachment unit 102, and a plurality of solar cell units 104, which are attached to the flexible strap device 103.

The plurality of flexible photovoltaic assemblies 100 is independent from each other. Each flexible photovoltaic assembly 100 is tensioned in the panel frame 11 with a predetermined pre-tension. As a result, the predetermined pre-tension in the tensioned flexible strap device 103 can be adjusted to requirements such as Eigenfrequency, maximum deflection or similar requirements.

Thereby, the plurality of flexible photovoltaic assemblies 100 extend parallel to each other in the panel plane 12. Here, the panel frame is made of a carbon fiber reinforced plastic (CFRP).

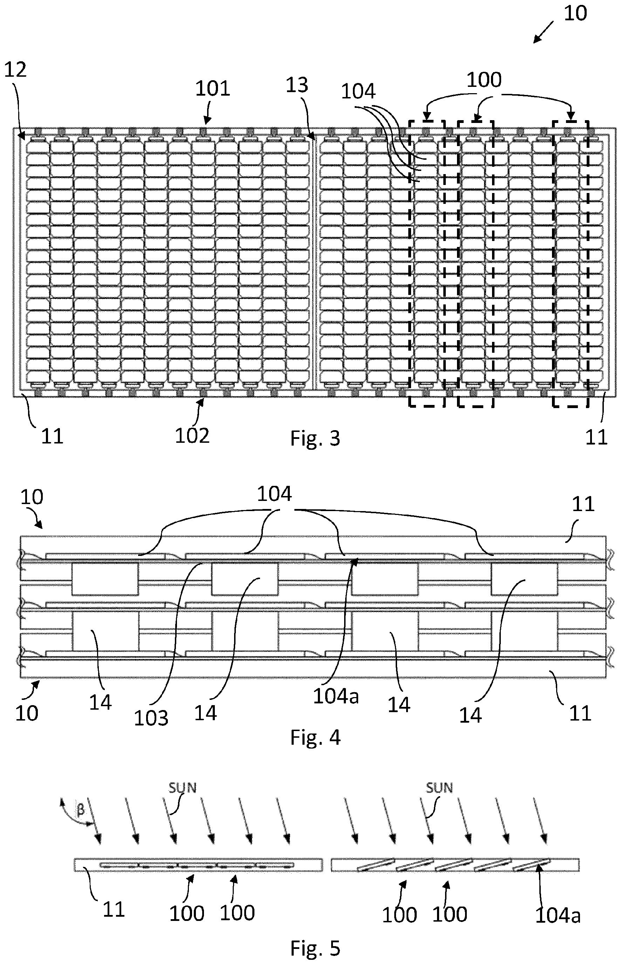

Fig. 3 shows a schematic illustration of a solar panel 10 with a panel frame stiffener 13.

The solar panel 10 in Fig. 3 substantially has the same features as the solar panel 10 as described in Fig. 2. Here the solar panel further comprises a panel frame stiffener 13 for stiffening the panel frame. The panel frame stiffener 13 is arranged in the planar installation area 12 and extends parallel in relation to the plurality of flexible photovoltaic assemblies 100.

Furthermore, two adjacent flexible photovoltaic assemblies can be mechanically coupled to each other. Thus, a risk of collision between those flexible photovoltaic assemblies can be reduced. For example, they can be mechanically coupled by a shared strap or by a cross coupling such as a bonded string or strap.

Fig. 4 shows a schematic side view of a plurality of solar panels 10 with a bumper 14 in a transport position. Specifically, three solar panels 10 are folded in the transport position.

Here the solar panel 10 comprises bumpers 14, which are arranged at the rear side 104a of the solar cell units 104 in the transport position, in which the solar panel 10 is retained on top of another solar panel 10. Hence, an out-of-plane deflection of the flexible strap device 103 can be reduced. Furthermore, a direct contact between the solar cell units 104 can be prevented during vibration and the amplitude can be reduced. The bumper 14 is configured as a honeycomb bumper. Exemplarily, the bumper 14 is attached to the rear side 104a of the solar cell unit 104.

Fig. 5 shows a schematic illustration of a solar panel 10 with flexible photovoltaic assemblies 100 having an angle β relative to the planar installation area 12. Specifically, the solar panel 10 on the left hand side does not have an angle. The flexible photovoltaic assemblies 100 are arranged plane in the planar installation area 12. In contrast to that, the solar panel 10 on the right hand side illustrates flexible photovoltaic assemblies 100 having an angle β relative to the planar installation area 12.

Hence, a variable adjustment with pre-defined angles could be provided. Therefore, the angle β of the solar cell unit 104 can be adjusted depending on different missions. The angle β can be predetermined and provided by an anti-twist protection or by a correspondingly configured attachment unit, for example. Here, a rear side 104a of the solar cell unit 104 is in contact with a flexible strap device 103.

Furthermore, the first and the second attachment unit 101, 102 can comprise a controllable tilting drive (not shown) for automatically adjusting the angle β depending on an inclination of the sun SUN. For example, an alignment mechanism integrated in the panel frame can be used.

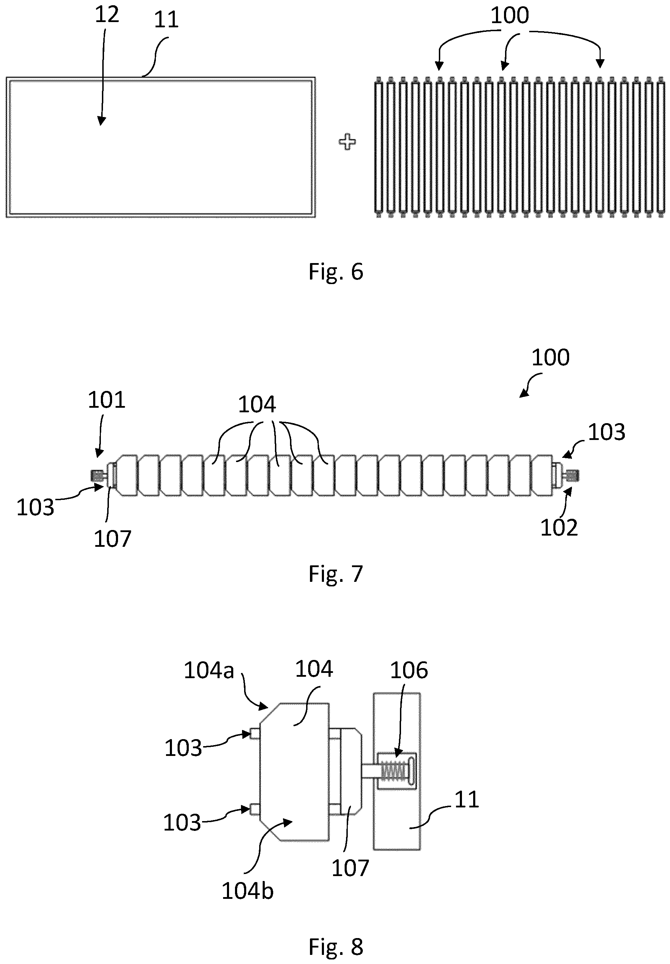

Fig. 6 shows a schematic illustration of a panel frame 11 and a plurality of independent flexible photovoltaic assemblies 100.

In Fig. 6, the main components of the solar panel 10 are illustrated, which are the panel frame 11 and the flexible photovoltaic assembly 100. This example emphasizes on the independency of both main components in a manufacturing process, wherein the flexible photovoltaic assembly 100 can be mounted to the panel frame 11.

Fig. 7 shows a schematic illustration of a flexible photovoltaic assembly 100.

The flexible photovoltaic assembly 100 comprises a first attachment unit 101 and a second attachment unit 102 spaced apart from the first attachment unit 101. Furthermore, the first and the second attachment unit 101, 102 both comprise a tension rocker 107.

The flexible photovoltaic assembly 100 further comprises a flexible strap device 103, which is attached to the first attachment unit 101 and to the second attachment unit 102. Here, the flexible strap device 103 is configured to be isolated. Hence, the flexible strap device 103 is electrically insulated, for example by an insulation film, in order to prevent electrical short circuiting. For example, carbon fibers are integrated in the flexible strap device 103. Therefore, an insulating coating like a polyimide film is provided on the surface of the flexible strap device 103 to provide a robust electrical insulation.

Moreover, the flexible photovoltaic assembly 100 comprises at least one solar cell unit 104, which is attached to the flexible strap device 103. Exemplarily, the at least one solar cell unit 104 is attached to the flexible strap device 103 by a press fit like clamps or a magnetic connection. The at least one solar cell unit 104 comprises a plurality of solar cell units, which are arranged in series between the first and the second attachment unit 101, 102.

Fig. 8 shows a schematic illustration of an attachment unit 101; 102 of the flexible photovoltaic assembly 100 of Fig. 7.

Here, the flexible strap device 103 comprises two straps, which extend parallel between the first and the second attachment unit 101, 102.

The attachment unit 101; 102 comprises a tensioning mechanism 106 for tensioning the flexible strap device 103 when mounted to a panel frame 11. Hence, an applied pre-tension on the flexible strap device 103 can substantially be kept constant. For example, the tensioning mechanism 106 comprises a tension spring.

The predetermined pre-tension can be exactly adjusted by using the tension spring 106 and the tension rocker 107 for each flexible strap device 103. Hence, an even load distribution throughout the complete solar panel 10 can be improved.

Further, the solar cell unit 104 comprises a bi-facial solar cell having a rear side 104a and a front side 104b, wherein the rear side 104a faces away from the sun and converts light into power, which is reflected, in particular reflected from the earth towards the rear side 104a. As a result, an efficiency of power generating can be further improved.

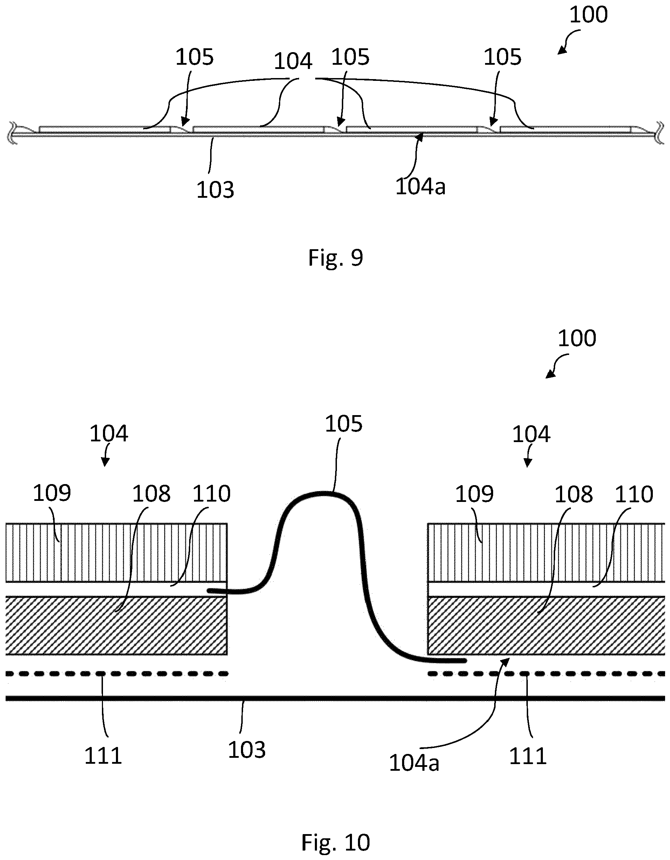

Fig. 9 shows a schematic illustration of the flexible photovoltaic assembly 100 of Fig. 7 having solar cell units 104 arranged in series.

The flexible photovoltaic assembly 100 exemplarily corresponds to the flexible photovoltaic assembly 100 of Fig. 7. Furthermore, the flexible photovoltaic assembly 100 comprises a solar cell interconnector 105.

The solar cell units 104 have a rear side 104a for attaching the flexible strap device 103, wherein the rear side 104a is facing the flexible strap device 103 and at least sectionwise has a black surface. For example, a part of the rear side 104a is facing deep space, except the area above the flexible strap device 103, and can get rid of the heat by radiating into deep space. Thus, thermo-optical properties leading to moderate cell temperatures and a higher cell efficiency can be improved.

Fig. 10 shows a schematic cross-sectional detail view of adjacent solar cell units 104 being electrically connected by a solar cell interconnector 105.

Exemplarily, the solar cell unit 104 is attached to the flexible strap device 103 by a material bonding like adhesion. Adjacent solar cell units 104 are electrically connected by a solar cell interconnector 105, as it is shown in Fig. 10 for example. The solar cell interconnector 105 is configured mechanically flexible, in particular bendable. Thus, the solar cell interconnector 105 can provide a mechanical flexibility to the adjacent solar cell units 104 such that they can pivot relative to each other.

The solar cell unit comprises here a solar cell 108 and a cover glass 109 on top of the solar cell 108. The cover glass 109 is bonded to the solar cell 108 by a cover glass adhesive 110. The cover glass 108 corresponds to a front side of the solar cell unit 104.

Furthermore, the solar cell 108 is bonded to the flexible strap device 103 by a solar cell adhesive 111. The solar cell adhesive 111 is provided on a rear side 104a of the solar cell unit 104.

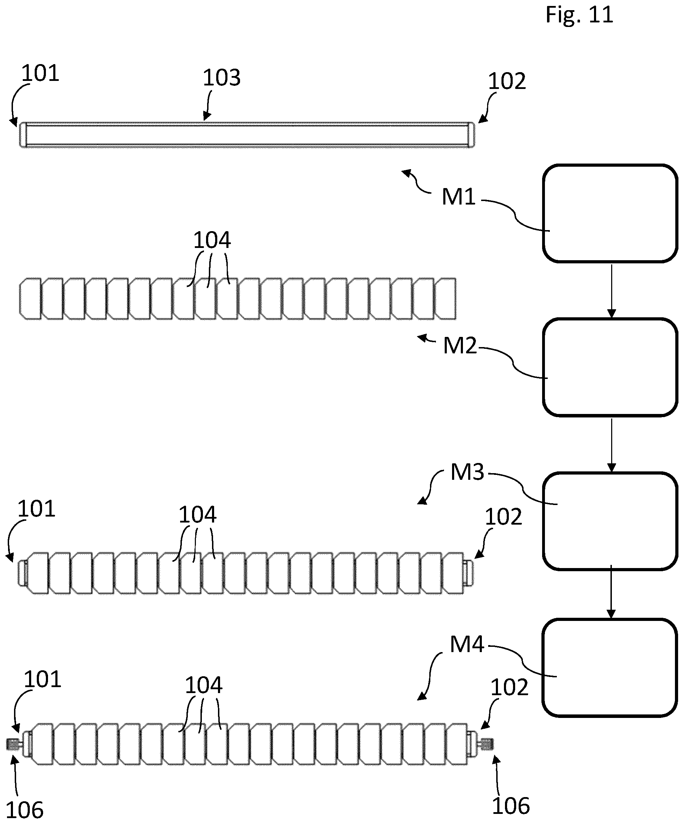

Fig. 11 shows a flow chart for a method for manufacturing a flexible photovoltaic assembly 100.

The method comprises the steps of attaching M1, providing M2, attaching M3 and integrating M4.

Exemplarily, the steps M1-M4 are illustrated graphically for visualizing those steps.

In the step of attaching M1, a flexible strap device 103 is attached to a first attachment unit 101 and a second attachment unit 102 spaced apart from the first attachment unit 101.

In the step of providing M2, at least one solar cell unit 104 as described in Fig. 1 to 10 is provided. Further, a plurality of solar cell units is arranged in series between the first and the second attachment unit 101, 102. Additionally, adjacent solar cell units 104 of the plurality of solar cell units are electrically connected by a solar cell interconnector 105.

In the step of attaching M3, the at least one solar cell unit 104 is attached to the flexible strap device 103.

The step of attaching the flexible strap device and the step of providing at least one solar cell unit can be performed parallel, in particular simultaneously.

In the step of integrating M4, a tensioning mechanism 106 is integrated into the first and the second attachment unit 101, 102 for tensioning the flexible strap device 103 when mounted to a panel frame 11.

After performing the steps M1-M4 a flexible photovoltaic assembly 100 according to one of the Figs. 1 to 10 is obtained. Such a flexible photovoltaic assembly 100 can be mounted to a panel frame 11 as it is illustrated in particular in Figs. 2, 3, 4 and 6.

In the detailed description above, various features have been combined in one or more examples in order to improve the rigorousness of the illustration. However, it should be clear in this case that the above description is of merely illustrative but in no way restrictive nature. It serves to cover all alternatives, modifications and equivalents of the various features and exemplary embodiments. Many other examples will be immediately and directly clear to a person skilled in the art on the basis of his knowledge in the art in consideration of the above description.

The exemplary embodiments have been chosen and described in order to be able to present the principles underlying the invention and their application possibilities in practice in the best possible way. As a result, those skilled in the art can optimally modify and utilize the invention and its various exemplary embodiments with regard to the intended purpose of use. In the claims and the description, the terms "including" and "having" are used as neutral linguistic concepts for the corresponding terms "comprising". Furthermore, use of the terms "a", "an" and "one" shall not in principle exclude the plurality of features and components described in this way.

While at least one exemplary embodiment of the present invention(s) is disclosed herein, it should be understood that modifications, substitutions and alternatives may be apparent to one of ordinary skill in the art and can be made without departing from the scope of this disclosure. This disclosure is intended to cover any adaptations or variations of the exemplary embodiment(s). In addition, in this disclosure, the terms "comprise" or "comprising" do not exclude other elements or steps, the terms "a" or "one" do not exclude a plural number, and the term "or" means either or both. Furthermore, characteristics or steps which have been described may also be used in combination with other characteristics or steps and in any order unless the disclosure or context suggests otherwise. This disclosure hereby incorporates by reference the complete disclosure of any patent or application from which it claims benefit or priority.

### Reference list

- 1: spacecraft
- 2: solar generator wing
- 3: yoke

- 10: solar panel
- 11: panel frame
- 12: planar installation area
- 13: panel frame stiffener
- 14: bumper

- 100: flexible photovoltaic assembly
- 101: first attachment unit
- 102: second attachment unit
- 103: flexible strap device
- 104: solar cell unit
- 105: solar cell interconnector
- 106: tensioning mechanism
- 107: tension rocker
- 108: solar cell
- 109: cover glass
- 110: cover glass adhesive
- 111: solar cell adhesive

- M1: attaching
- M2: providing
- M3: attaching
- M4: integrating

- SUN: sun

## Claims

1. Flexible photovoltaic assembly (100) comprising:
a first attachment unit (101) and a second attachment unit (102) spaced apart from the first attachment unit (101);
a flexible strap device (103), which is attached to the first attachment unit (101) and to the second attachment unit (102); and
at least one solar cell unit (104), which is attached to the flexible strap device (103).

2. Flexible photovoltaic assembly (100) according to claim 1, wherein the at least one solar cell unit (104) is attached to the flexible strap device (103) by a material bonding like welding or adhesion, by a form fit like a velcro fastener or a lug tab connection, and/or by a press fit like clamps or a magnetic connection.

3. Flexible photovoltaic assembly (100) according to claim 1 or 2, wherein the flexible strap device (103) is configured to be isolated or non-conductive.

4. Flexible photovoltaic assembly (100) according to one of the preceding claims, wherein the at least one solar cell unit (104) comprises a plurality of solar cell units, which are arranged in series between the first and the second attachment unit (101, 102), wherein adjacent solar cell units (104) of the plurality of solar cell units are electrically connected by a solar cell interconnector (105).

5. Flexible photovoltaic assembly (100) according to one of the preceding claims, wherein the first and/or second attachment unit (101, 102) comprises a tensioning mechanism (106) for tensioning the flexible strap device (103) when mounted to a panel frame (11).

6. Flexible photovoltaic assembly (100) according to one of the preceding claims, wherein the at least one solar cell unit (104) has a rear side (104a) for attaching the flexible strap device (103), wherein the rear side (104a) is facing the flexible strap device (103) and at least sectionwise has a black surface.

7. Flexible photovoltaic assembly (100) according to one of the claims 1 to 5, wherein the at least one solar cell unit (104) comprises a bi-facial solar cell having a rear side (104a) and a front side (104b), wherein the rear side (104a) faces away from the sun and converts light into power, which is reflected, in particular reflected from the earth towards the rear side (104a).

8. Solar panel (10) comprising:
a panel frame (11), which at least partly surrounds a planar installation area (12); and
a first flexible photovoltaic assembly (100) according to one of the preceding claims, which is arranged in the planar installation area (12) and mounted to the panel frame (11) by means of its first and second attachment unit (101, 102).

9. Solar panel (10) according to claim 8, wherein the first flexible photovoltaic assembly (100) is tensioned in the panel frame (11) with a predetermined pre-tension.

10. Solar panel (10) according to claim 8 or 9, further comprising a second flexible photovoltaic assembly (100), which extends parallel to the first flexible photovoltaic assembly (100) in the planar installation area (12) and is mounted to the panel frame (11) by means of its first and second attachment unit (101, 102).

11. Solar panel (10) according to one of the claims 8 to 10, further comprising a panel frame stiffener (13) for stiffening the panel frame, wherein the panel frame stiffener (13) is arranged in the planar installation area (12) and extends parallel or perpendicular in relation to the first flexible photovoltaic assembly (100).

12. Solar panel (10) according to one of the claims 8 to 11, further comprising a bumper (14), which is arranged at the rear side (104a) of the at least one solar cell unit (104) in a transport position, in which the solar panel (10) is retained on top of another solar panel.

13. Solar panel (10) according to one of the claims 8 to 12, wherein the first flexible photovoltaic assembly (100) or its at least one solar cell unit (104) has an angle (β) relative to the planar installation area (12).

14. Solar panel (10) according to claim 13, wherein the first and the second attachment unit (101, 102) comprises a controllable tilting drive for automatically adjusting the angle (β) depending on an inclination of the sun (SUN).

15. Spacecraft (1) with a solar generator wing (2) comprising a solar panel (10) according to one of the claims 8 to 14.

16. Method for manufacturing a flexible photovoltaic assembly, in particular a flexible photovoltaic assembly (100) according to one of the claims 1 to 7, the method comprising the steps of:
attaching (M1) a flexible strap device (103) to a first attachment unit (101) and a second attachment unit (102) spaced apart from the first attachment unit (101);
providing (M2) at least one solar cell unit (104); and
attaching (M3) the at least one solar cell unit (104) to the flexible strap device (103).

17. Method according to claim 16, wherein the step of providing (M2) includes arranging a plurality of solar cell units in series between the first and the second attachment unit (101, 102), and electrically connecting adjacent solar cell units (104) of the plurality of solar cell units by a solar cell interconnector (105).

18. Method according to claim 16 or 17, further comprising a step of integrating (M4) a tensioning mechanism (106) into the first and/or second attachment unit (101, 102) for tensioning the flexible strap device (103) when mounted to a panel frame (11).
